Europäisches Patentamt

European Patent Office

Office européen des brevets

(11) Veröffentlichungsnummer: **0 433 720 A2**

# (12) EUROPÄISCHE PATENTANMELDUNG

(21) Anmeldenummer: 90122755.3

(22) Anmeldetag: 28.11.90

(51) Int. Cl.5: **H05K 3/34**

(30) Priorität: 22.12.89 DE 3942742

(43) Veröffentlichungstag der Anmeldung:
26.06.91 Patentblatt 91/26

(84) Benannte Vertragsstaaten:
AT BE CH DE FR GB IT LI NL SE

(71) Anmelder: **Siemens Aktiengesellschaft**
**Wittelsbacherplatz 2**
**W-8000 München 2(DE)**

(72) Erfinder: **Schmidt, Hans-Fr., Dr.**
**Graf Tattenbachweg 3b**
**W-8191 Eurasburg(DE)**
Erfinder: **Hadwiger, Helmut**
**Friedrich-Herschel-Strasse 5**
**W-8000 München 80(DE)**
Erfinder: **Prochazka, Milan**
**Beblostrasse 15**
**W-8000 München 80(DE)**
Erfinder: **Roelants, Eddy, Dr.**
**P. Ascanusstrasse 31**
**B-1700 Asse(BE)**

(54) **Verfahren zum Aufbringen einer Lötstoppabdeckung auf Leiterplatten.**

(57) Auf die Leiterplatte werden nacheinander ganz-flächig ein Lötstopplack (5) und ein positiv arbeiten-des Fotoresist (6) aufgebracht, worauf das Fotoresist (6) vorzugsweise mit Hilfe von Laserstrahlen (Ls) im Bereich von Durchkontaktierungen (3) und/oder Lötpads (4) selektiv belichtet und entwickelt wird. Da-nach wird in den nicht durch das Fototresist (6) geschützten Bereichen, d.h. in den Bereichen von Durchkontaktierungen (3) und/oder Lötpads (4) der Lötstopplack (5) gestrippt und als letzter Schritt das verbliebene Fototresist (6) ebenfalls gestrippt. Das erfindungsgemäße Verfahren ist insbesondere für das Aufbringen einer Lötstoppabdeckung auf dreidi-mensionale Leiterplatten geeignet, da hier herkömm-liche Maskentechniken zur Strukturierung des Löt-stopplacks nicht anwendbar sind.

FIG 4

# VERFAHREN ZUM AUFBRINGEN EINER LÖTSTOPPABDECKUNG AUF LEITERPLATTEN

Die Erfindung betrifft ein Verfahren zum Aufbringen einer Lötstoppabdeckung auf das Leiterbild von Leiterplatten, insbesondere von dreidimensionalen Leiterplatten, unter Freilassung von Durchkontaktierungen und/oder Lötpads.

Bei der Herstellung von Leiterplatten soll nach der Strukturierung des Leiterbildes auf diejenigen Bereiche des Leiterbildes die keine Lötverbindung eingehen sollen eine Lötstoppabdeckung aufgebracht werden. Diese Lötstoppabdeckung läßt nur Durchkontaktierungen und/oder Lötpads frei, so daß dort dann durch Heißverzinnen oder durch einen Umschmelzvorgang eine lötfähige Endoberfläche erzeugt werben kann. Das Aufbringen der Lötstoppabdeckung kann dabei durch selektives Auftragen eines Lötstopplackes auf die zu schützenden Bereiche oder durch ganzflächiges Auftragen eines lichtempfindlichen Lötstopplackes mit anschließender Fotostrukturierung vorgenommen werden. Das selektive Auftragen ist dabei mit einem zu großen Aufwand verbunden, während die Fotostrukturierung insbesondere bei dreidimensionalen Leiterplatten mit herkömmlichen Maskentechniken nicht durchführbar ist.

Der Erfindung liegt die Aufgabe zugrunde ein wirtschaftliches Verfahren zum Aufbringen einer Lötstoppabdeckung auf Leiterplatten zu schaffen, das auch bei dreidimensionalen Leiterplatten anwendbar ist.

Die Lösung dieser Aufgabe erfolgt durch folgende Verfahrensschritte:

a) auf die Leiterplatte wird ganzflächig ein Lötstopplack aufgebracht;

b) auf den Lötstopplack wird ganzflächig ein positiv arbeitendesFotoresist aufgebracht;

c) das Fotoresist wird in Bereich von Durchkontaktierungen und/oder Lötpads selektiv belichtet und entwickelt;

d) die im Schritt c) freigelegten Bereiche des Lötstopplacks werden gestrippt;

e) das Fotoresist wird gestrippt.

Bei dem erfindungsgemäßen Verfahren erfolgt also das Aufbringen der Lötstoppabdeckung durch ganzflächiges Auftragen eines normalen Lötstopplackes und anschließendes selektives Entfernen bzw. Strippen dieses Lötstopplackes im Bereich von Durchkontaktierungen und/oder Lötpads. Diese Vorgehensweise wird durch die entsprechende Fotostrukturierung eines positiv arbeitenden Fotoresists ermöglicht, welches beim Strippen der unerwünschten Bereiche des Lötstopplackes als Schutzmaske für die übrigen Bereiche des Lötstopplackes dient. Durch die Verwendung des positiv arbeitenden Fotoresists kann zur Strukturierung des Lötstopplackes auf bewährte Techniken zurückgegriffen werden, die auch bei dreidimensionalen Leiterplatten problemlos durchgeführt werden können. Dabei ist insbesondere hervorzuheben, daß auch im kritischen Innenbereich von Durchkontaktierungen das ausreichende Belichten und Entwickeln des Fotoresists sowie das Strippen des Lötstopplackes ohne Schwierigkeiten durchgeführt werden kann. Die Nachteil der Fotostrukturierung lichtempfindlicher Lötstopplacke können also durch die Verwendung normaler Lötstopplacke in Verbinoung mit einem positiv arbeitenden Fotoresist umgangen werden.

Nach dem Strippen des Fotoresists kann der Lötstopplack problemlos thermisch gehärtet werden.

Gemäß einer bevorzugten Ausgestaltung des erfindungsgemäßen Verfahrens wird die selektive Belichtung des Fotoresists im Bereich der Durchkontaktierungen und/oder Lötpads mit Hilfe eines Lasers vorgenommen. Die Laserstrahlen können dabei insbesondere gezielt in die Durchkontaktierungslöcher gerichtet werden und dort für eine einwandfreie Belichtung des Fotoresists sorgen. Die Bewegung des Laserstrahls relativ zur Leiterplattesollte dann vorzugsweise frei programmierbar sein, d.h. die Umschreibung und Belichtung von Durchkontaktierungen und/oder Lötpads kann auf besonders einfache Weise vorgenommen werden.

Gemäß einer weiteren bevorzugten Ausgestaltung der Erfindung werden mit dem im Schritt c) verwendeten Entwickler gleichzeitig die durch das Entwickeln freigelegten Bereiche des Lötstopplacks gestrippt. In diesem Fall wird das Entwickeln des Fotoresists und das Strippen des Lötstopplacks also in einem Arbeitsgang durchgeführt.

Die Vorteile des erfindungsgemäßen Verfahrens kommen insbesondere dann zum Tragen, wenn der Lötstopplack auf eine Leiterplatte mit einem dreidimensionalen spritzgegossenen Substrat und eingespritzten Durchkontaktierungslöchern aufgebracht wird.

Ein Ausführungsbeispiel der Erfindung ist in der Zeichnung dargestellt und wird im folgenden näher beschrieben.

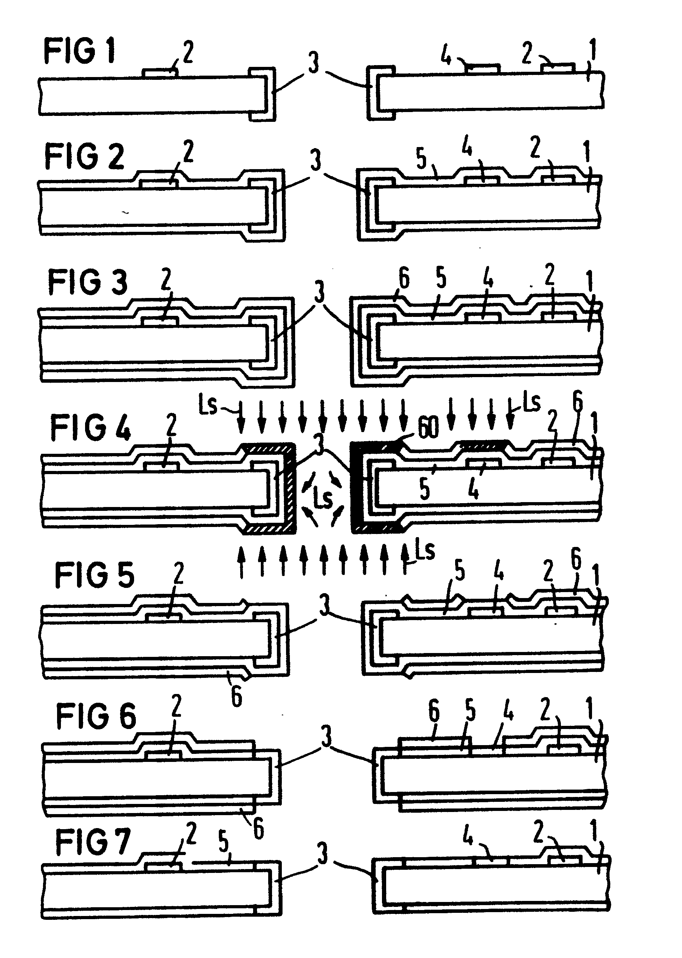

Die Figuren 1 bis 7 zeigen in stark vereinfachter schematischer Darstellung die verschiedenen Verfahrensstadien bei dem Aufbringen einer Lötstoppabdeckung auf Leiterplatten.

Vor der detaillierten Beschreibung ist noch darauf hinzuweisen, daß der Begriff "Leiterplatte" und auch die vereinfachte Zeichnung zunächst auf ein flächiges Gebilde schließen lassen. Die Vorteile des erfindungsgemäßen Verfahrens, bei dem auf übliche Maskentechniken verzichtet werden kann, sind jedoch genau darin zu sehen, daß von der ebenen Form abgewichen werden kann und dreidimensionale Leiterplatten mit beliebigen abgewinkelten oder gekrümmten Formen mit einer Lötstoppabdeckung versehen werden können.

Fig. 1 zeigt einen Schnitt durch einen Teil einer Leiterplatte, auf deren elektrisch isolierendes Substrat 1 als Leiterbild Leiterbahnen 2, Durchkontaktierungen 3 und Lötpads 4 aufgebracht wurden. Bei dem dargestellten Substrat 1 handelt es sich um ein spritzgegossenes Basismaterial mit eingespritzten Löchern für die Durchkontaktierungen 3. Als Material für ein derartiges Substrat 1 ist beispielsweise glasfaserverstärktes Polyetherimid geeignet.

Zum Aufbringen einer Lötstoppabdeckung auf das Leiterbild der in Fig. 1 ausschnittsweise dargestellten Leiterplatte unter Freilassung von Durchkontaktierungen 3 und Lötpads 4 wird nun zunächst gemäß Fig. 2 ganzflächig durch Tauchen oder durch elektrostatisches Sprühen ein Lötstopplack 5 aufgebracht. Bei diesem Lötstopplack 5, der beispielsweise mit einer Stärke zwischen 20 und 30 Mikrometern aufgebracht wird, handelt es sich um ein handelsübliches Produkt auf Epoxidharzbasis, z.B. um das unter dem Handelsnamen ELPEMER 2468 erhältliche Produkt der Fa. Peters, D-4152 Kempen, DE.

Nach dem Aufbringen des Lötstopplacks 5 wird gemäß Fig. 3 ganzflächig durch Tauchen, Spritzen oder dergleichen ein positiv arbeitendes Fotoresist 6 aufgebracht. Bei diesen Fotoresist 6 handelt es sich um ein handelsübliches Produkt, welches durch fotochemischen Abbau unter Umwandlung von funktionellen Gruppen leicht löslich wird. Derartige Fotoresists werden beispielsweise bei der Herstellung von Leiterplatten als Ätzresists eingesetzt. Geeignet ist beispielsweise das unter dem Handelsnamen OZATEC von der Farbwerke Hoechst AG, 6230 Frankfurt (Main) 80, DE vertriebene Fotoresist.

Gemäß Fig. 4 wird anschließend das Fotoresist 6 im Bereich der Durchkontaktierungen 3 und der Lötpads 4 mit Hilfe eines Lasers in einem Scan-Verfahren belichtet, wobei die Laserstrahlung durch Pfeile Ls lediglich angedeutet ist. Die Pfeile im Innenbereich der Durchkontaktierung sollen aufzeigen, daß die Belichtung des Fotoresists 6 im Bereich der Lochwandung durch einen schrägen Einfall der Laserstrahlen Ls verbessert werden kann. Die belichteten Bereiche des Fotoresists 6 sind in Fig. 4 durch eine Schwärzung hervorgehoben und mit der Bezugsziffer 60 gekennzeichnet.

Gemäß Fig. 5 werden die durch die Belichtung löslich gewordenen Bereiche 60 des Fotoresists 6 entfernt. Diese Entfernung der Bereiche 60 wird unter Verwendung eines üblichen Entwicklers auf der Basis organischer Lösemittel durchgeführt.

Nach beendeter Entwicklung werden gemäß Fig. 6 die nunmehr freiliegenden Bereiche des Lötstopplacks 5 gestrippt. Dies bedeutet mit anderen Worten, daß der Lötstopplack 5 im Bereich der Durchkontaktierungen 3 und der Lötpads 4 wieder entfernt wird. Das selektive Strippen des Lötstopplacks 5 wird beispielsweise in wäßrigen alkalischen Lösungen, vorzugsweise in einer wäßrigen KOH-Lösung, vorgenommen. Das unbelichtete Fotoresist 6 ist gegen derartige wäßrige alkalische Lösungen resistent. Es ist aber auch möglich einen durch organische Lösemittel wie z.B. Butyldiglykol strippbaren Lötstopplack 5 zu verwenden, wobei das Fotoresist 6 in diesem Fall gegen derartige organische Lösemittel resistent sein muß. Geeignet ist beispielsweise der unter dem Handelsnamen ELPEMER 2469 von der Fa. Peters, D-4152 Kempen, DE vertriebene Lötstopplack in Verbindung mit dem in wäßrig alkalischen Lösungen entwickelbaren und strippbaren Fotoresist AZ 1400 der Farbwerke Hoechst AG, 6230 Frankfurt (Main) 80, DE. Alternativ zu dem aufgezeigten Strippen des Lötstopplacks 5 kann dessen Entfernung aber auch mit dem Entwickler für die belichteten Bereiche des Fotoresists 6 vorgenommen werden, d.h. in diesem Fall kann ein Verfahrensschritt eingespart werden.

Nach dem selektiven Entfernen des Lötstopplacks 5 brauchen dann nur noch die verbliebenen, unbelichteten Bereiche des Fotoresists 6 entfernt zu werden. Nach diesem Entfernen des Fotoresists 6 in einem handelsüblichen Stripper verbleiben gemäß Fig. 7 nur noch diejenigen Bereiche des Lötstopplacks 5, die das Leiterbild unter Freilassung der Durchkontaktierungen 3 und der Lötpads 4 vollständig abdecken. Diese verbliebenen Bereiche des Lötstopplacks 5 werden dann bei einer Temperatur von ca. 120° C ca. 30 Minuten lang thermisch gehärtet. Durch anschließendes Heißverzinnen können dann die Durchkontaktierungen 3 und die Lötpads 4 problemlos selektiv mit einer Zinn-Blei-Legierung überzogen werden. Wenn bereits vor dem ganzflächigen Aufbringen des Lötstopplacks 5 auf die Leiterplatte auf deren Leiterbahnen 2, Durchkontaktierungen 3 und Lötpads 4 eine Endoberfläche durch galvanische Abscheidung von Zinn oder einer Zinn-Blei-Legierung aufgebracht worden ist, so ist nur noch ein Umschmelzprozeß zur Verbesserung der Lötbarkeit im Bereich der Durchkontaktierungen 3 und der Lötpads 4 erforderlich.

## Ansprüche

1. Verfahren zum Aufbringen einer Lötstoppabdeckung auf das Leiterbild von Leiterplatten, insbesondere von dreidimensionalen Leiterplatten, unter Freilassung von Durchkontaktierungen und/oder Lötpads, mit folgenden Verfahrensschritten:

a) auf die Leiterplatte wird ganzflächig ein Lötstopplack (5) aufgebracht;

b) auf den Lötstopplack (5) wird ganzflächig ein positiv arbeitendes Fotoresist (6) aufgebracht;

c) das Fotoresist (6) wird im Bereich von Durchkontaktierungen (3) und/oder Lötpads (4) selektiv belichtet und entwickelt;

d) die im Schritt c) freigelegten Bereiche des Lötstopplacks (5) werden gestrippt;

e) das Fotoresist (6) wird gestrippt.

2. Verfahren nach Anspruch 1,
   **dadurch gekennzeichnet,**
   daß der Lötstopplack (5) nach dem Strippen des Fotoresists (6) thermisch gehärtet wird.

3. Verfahren nach Anspruch 1 oder 2,
   **dadurch gekennzeichnet,**
   daß die selektive Belichtung des Fotoresists (6) im Bereich der Durchkontaktierungen (3) und/oder Lötpads (4) mit Hilfe eines Lasers vorgenommen wird.

4. Verfahren nach Anspruch 3,
   **dadurch gekennzeichnet,**
   daß die Bewegung des Laserstrahls (Ls) relativ zur Leiterplatte frei programmierbar ist.

5. Verfahren nach einem der vorhergehenden Ansprüche,
   **dadurch gekennzeichnet,**
   daß mit dem im Schritt c) verwendeten Eintwickler gleichzeitig die durch das Entwickeln freigelegten Bereiche des Lötstopplacks (5) gestrippt werden.

6. Verfahren nach einem der vorhergehenden Ansprüche,
   **dadurch gekennzeichnet,**
   daß der Lötstopplack (5) auf eine Leiterplatte mit einem dreidimensionalen spritzgegossenen Substrat (1) und eingespritzten Durchkontaktierungslöchern aufgebracht wird.

FIG 1

FIG 2

FIG 3

FIG 4

FIG 5

FIG 6

FIG 7